# EUROPEAN PATENT SPECIFICATION

(11) **EP 4 478 400 B1**
(45) Date of publication and mention of the grant of the patent: **30.07.2025**
(21) Application number: 23178918.1
(22) Date of filing: 13.06.2023
(51) Int. Cl.: H01L 21/54, H01L 21/56, H01L 23/053, H01L 23/31, H01L 23/373, H01L 25/07, H01L 23/498

(54) **METHOD FOR FORMING A POWER SEMICONDUCTOR MODULE ARRANGEMENT**
VERFAHREN ZUR HERSTELLUNG EINER LEISTUNGSHALBLEITERMODULANORDNUNG
PROCÉDÉS DE FORMATION D'UN AGENCEMENT DE MODULE SEMI-CONDUCTEUR DE PUISSANCE

(43) Date of publication of application: 18.12.2024
(73) Proprietor: Infineon Technologies AG, 85579 Neubiberg (DE)
(72) Inventor: SCHMER, Alexander, 59494 Soest (DE); HERZER, Anita, 67655 Kaiserslautern (DE); HARTUNG, Hans, 59581 Warstein (DE); GOLDAMMER, Martin, 59494 Soest (DE)
(74) Representative: Westphal, Mussgnug & Partner, Patentanwälte mbB

(56) References cited:
- DE-A1- 102020 131 493

## Description

### TECHNICAL FIELD

The instant disclosure relates to methods for forming a power semiconductor module arrangement, in particular to method for forming a power semiconductor module arrangement comprising an encapsulant.

### BACKGROUND

Document DE 10 2020 131493 A1 discloses an interlinked system for carrying out a method for producing a power electronic switching device with the following method steps: Providing a substrate with an insulating material body with conductor tracks, with a power semiconductor component being arranged on the first conductor track and this being electrically conductively connected to the second conductor track with an internal connecting device; applying a dam of a first material to an edge region of a first major surface of the substrate, thereby forming a filling region of the substrate surrounded by the dam; introducing a light-induced crosslinking second material into the filling area; initiation of the crosslinking of the second material by irradiation with UV light by means of a UV exposure device having a plurality of UV LEDs; waiting for a waiting period; rotation of the switching device perpendicular to its normal direction; Arrangement of the switching device in a housing or partial housing.

Power semiconductor module arrangements often include a substrate within a housing. The substrate usually comprises a substrate layer (e.g., a ceramic layer), a first metallization layer deposited on a first side of the substrate layer and, optionally, a second metallization layer deposited on a second side of the substrate layer. A semiconductor arrangement including one or more controllable semiconductor elements (e.g., two IGBTs in a half-bridge configuration) may be arranged on the substrate. One or more terminal elements (contact elements), which allow for contacting such a semiconductor arrangement from outside the housing, are usually provided. Power semiconductor modules are known, where the terminal elements are arranged on the substrate and protrude in a direction that is essentially perpendicular to the main surface of the substrate through a cover of the housing. The section of the contact elements which protrudes out of the housing may be mechanically and electrically coupled to a printed circuit board. The housing may be glued to the substrate in order to remain in a desired position until the substrate is permanently attached to a base plate or heat sink by means of additional connecting elements. Gluing the housing to the substrate, however, requires additional pretreatment steps (e.g., a plasma treatment of the substrate), a step in which the glue is applied to the substrate, as well as a hardening step in which the originally viscous glue is hardened, thereby attaching the housing to the substrate. Each additional step during the assembly process requires additional process time and increases the overall cost of the power semiconductor module arrangement.

There is a need for a power semiconductor module arrangement that may be assembled in an effective and cost-efficient way.

### SUMMARY

The invention is set out in the appended set of claims.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a step of a method for forming a power semiconductor module arrangement according to embodiments of the disclosure.
Figure 3 schematically illustrates another step of a method for forming a power semiconductor module arrangement according to embodiments of the disclosure. Figures 1 - 3 illustrate embodiments falling under the scope of the claims.
Figure 4 schematically illustrates a step of another method for forming a power semiconductor module arrangement according to examples not falling under the scope of the claims.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or may be included in a semiconductor chip. A semiconductor body has electrically connecting pads and includes at least one semiconductor element with electrodes.

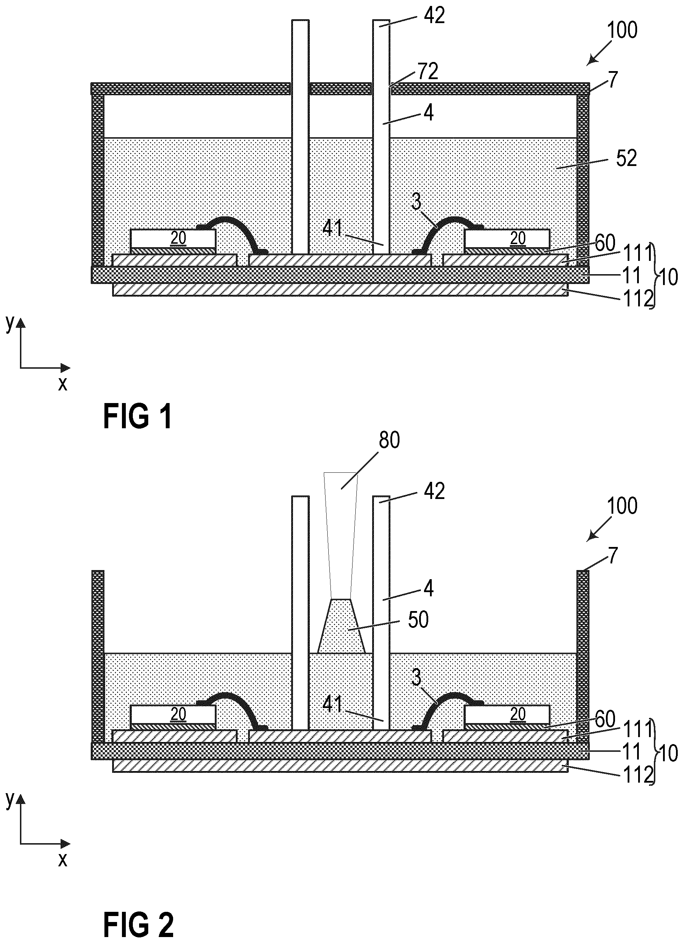

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AIN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base surface of the housing 7, while the housing 7 itself solely comprises sidewalls and, optionally, a cover. In some power semiconductor module arrangements 100, more than one substrate 10 is arranged within the same housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are mechanically and electrically connected to the substrate 10 (e.g., to the first metallization layer 111) and provide an electrical connection between the inside and the outside of the housing 7. The terminal elements 4 may be mechanically and electrically connected to the first metallization layer 111 with a first end 41, while a second end 42 of the terminal elements 4 protrudes out of the housing 7. The terminal elements 4 may be electrically contacted from the outside at their second end 42. The housing 7 may optionally be provided with a cover comprising a plurality of through holes 72 through which each of the plurality of terminal elements 4 vertically protrudes.

In addition to or instead of the terminal elements 4 described with respect to Figure 1, the components inside the housing 7 may also be electrically contacted from outside the housing 7 in any other suitable way. For example, additional terminal elements 4 may be arranged closer to or adjacent to the sidewalls of the housing 7. It is also possible that terminal elements 4 protrude vertically or horizontally through the sidewalls of the housing 7. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example.

Power semiconductor module arrangements 100 further include an encapsulant 52. The encapsulant 52 may consist of or include a silicone gel or may be a rigid molding compound, for example. The encapsulant 52 may at least partly fill the interior of the housing 7, thereby covering the components and electrical connections that are arranged on the substrate 10. The terminal elements 4 may be partly embedded in the encapsulant 52. At least their second ends 42, however, are not covered by the encapsulant 52 and protrude from the encapsulant 52 through the housing 7 to the outside of the housing 7. The encapsulant 52 is configured to protect the components and electrical connections of the power semiconductor module arrangement 100, in particular the components arranged on the substrate 10 inside the housing 7, from certain environmental conditions and mechanical damage.

The housing 7 may be glued to the substrate 10 in order to remain in a desired position until the substrate 10 is permanently attached to a base plate or heat sink by means of additional connecting elements. In particular, the housing 7 may be glued to the substrate 10 before filling a potting material 50 into the housing 7 which, after performing a hardening step, forms the encapsulant 52. The power semiconductor module arrangement 100 with the housing 7 glued to the substrate 10 and the encapsulant 52 arranged inside the housing 7 may then be shipped to a customer who then mounts the power semiconductor module arrangement 100 to a support structure such as a base plate or heat sink, for example. The power semiconductor module arrangement 100 may be mounted on a support structure (e.g., base plate or heat sink) by means of screws or bolts, for example, which serve to hold the substrate 10 in place and to force its lower surface into contact with the support structure. The glued joint between the housing 7 and the substrate 10 is therefore generally not needed to hold the housing 7 in its desired position with regard to the substrate 10 during operation of the power semiconductor module arrangement 100. The main purposes of the glued joint are to prevent the potting material 50 forming the encapsulant 52 from leaking out of the housing before being sufficiently hardened and to hold the housing 7 in its desired position with regard to the substrate 10 when shipping the power semiconductor module arrangement 100 to an end customer. Gluing the housing 7 to the substrate 10, however, requires additional pretreatment steps (e.g., a plasma treatment of the substrate 10), a step in which the glue is applied to the substrate 10, as well as a hardening step in which the originally viscous glue is hardened, thereby attaching the housing 7 to the substrate 10. Each additional step during the assembly process requires additional process time and increases the overall cost of the power semiconductor module arrangement 100.

In the following, methods for forming a power semiconductor module arrangement 100 according to embodiments of the disclosure will be described in which gluing the housing 7 to the substrate 10 is not required. That is, fewer steps are required for the methods described in the following, as compared to conventional methods. In this way, power semiconductor module arrangements can be assembled in a very effective and cost-efficient way. This is, because each additional step of the conventional methods requires time and adds to the overall production costs of a power semiconductor module arrangement 100.

A method for forming a power semiconductor module arrangement 100 according to embodiments of the disclosure, falling under the scope of the claims, comprises arranging a housing 7 on a substrate 10. The housing 7 may be attached to the substrate 10 in any suitable way without a glued joint between the sidewalls of the housing 7 and the substrate 10. For example, the housing 7 may be attached to the substrate 10 solely by means of a mechanical connection. Such a mechanical connection may be implemented in any suitable way. The mechanical connection may be sufficient to attach the housing to the substrate 10 while forming the encapsulant 52 and when shipping the power semiconductor module arrangement 100 to an end customer. For example, the power semiconductor module arrangement 100 may comprise specific holding pins that are arranged on the substrate 10 and extend from the substrate 10 in a vertical direction y towards the cover of the housing 7. The cover of the housing 7 may comprise holding elements (e.g., sleeves) that are configured to receive a free end of the holding pins, thereby forming a force-fitting connection. Additionally or alternatively it is also possible, for example, that one or more of the terminal elements 4 comprise a holding element arranged between the first end 41 and the second end 42 that is arranged inside a through hole in the cover of the housing 7, wherein each holding element exerts a force on the housing, thereby holding the housing in a desired position with regard to the substrate 10. Additionally or alternatively, a simple removable clamping mechanism could be used to hold the assembly together. Such mechanical connections, however, are only examples. A mechanical connection between the housing 7 and the substrate 10 may also be formed in any other suitable way.

As there is no glue between the housing 7 and the substrate 10, the sidewalls of the housing 7 (i.e. the lower surfaces of the sidewalls facing the substrate 10) are arranged on the substrate 10 to directly adjoin the substrate 10 (i.e. a top surface of the substrate 10, wherein the top surface of the substrate 10 may be a top surface of the dielectric insulation layer 11 or a top surface of the first metallization layer 111, wherein the top surface of the dielectric insulation layer 11 is a surface facing the first metallization layer 111, and the top surface of the first metallization layer 111 is a surface the semiconductor bodies 20 and any other elements of the power semiconductor module arrangement 100 are mounted to). However, when mounting the housing 7 to the substrate 10 without a glued joint between the housing 7 and the substrate 10, there is a risk that a potting material 50 that is filled into the housing 7 to form the encapsulant leaks out of the housing 7. Small gaps may be present at an interface between the housing 7 and the substrate 10. The potting material 50 that is filled into the housing 7 to form the encapsulant 52 is liquid, viscous or semi-liquid before it is hardened to form the encapsulant 52. The potting material 50 at least partly fills the housing 7 and covers the substrate 10 and most components mounted thereon, as is schematically illustrated in Figure 2. As has been described above, the terminal elements 4, for example, are generally not entirely covered by the potting material 50 and the encapsulant 52, respectively. The step of filling the potting material 50 into the housing 7, e.g., by means of a dispensing equipment 80, is schematically illustrated in Figure 2. According to some embodiments of the disclosure, the dispensing equipment 80 may be arranged centrally above the substrate 10. That is, the potting material 50 is dispensed centrally on the substrate 10 and, from there, spreads towards the edges of the substrate 10.

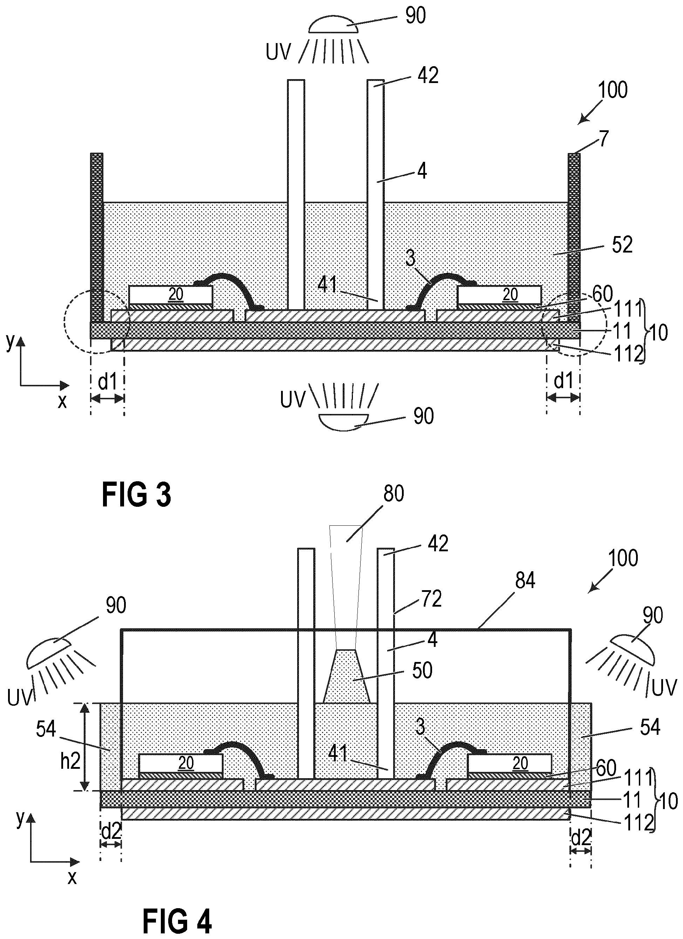

The potting material 50 is a UV-curable material. UV-curable materials typically include a photoinitiator which, when exposed to UV (ultraviolet) light, initiates cross-linking of the UV-curable material 50, causing it to harden. UV curable materials typically cure significantly more quickly than non-UV-curable materials. After dispensing the potting material 50 into the module housing 7 as shown in Figure 2, a UV light source 90 may be arranged above the module as shown in Figure 3, thereby irradiating the UV-curable potting material 50 inside the housing 7 and causing it harden rapidly. This part of the process is typically performed with no lid on top of the housing 7, of course, so that the UV light is able to reach the UV-curable potting material 50.

The UV-curable potting material 50 has a defined viscosity. The viscosity generally depends on the specific potting material 50 that is used to form the encapsulant 52. Such materials may, for example, take the form of epoxy resins or silicone gels. A liquid, viscous or semi-liquid UV-curable potting material that is suited to form the encapsulant 52 may have a viscosity of at least 900 mPa*s, for example. Some UV-curable potting materials 50 may have a viscosity of 925 mPa*s, others may have a viscosity of 1000 mPa*s, and some may have a viscosity of 8000 mPa*s, for example. Any other viscosity is generally possible. The higher the viscosity of the potting material 50, the lower its fluidity. Viscosity generally is the resistance of a material to a change in shape, or movement of neighboring portions relative to one another. Viscosity denotes opposition to flow. The reciprocal of the viscosity is called the fluidity, a measure of the ease of flow. A potting material 50 having a lower viscosity will leak out of the housing 7 faster than a potting material 50 having a higher viscosity. Generally, there may be significant leakage already within a very short timeframe, e.g., within several tens of seconds, one minute, or two minutes, for example, even when relatively fast-curing UV-curable potting materials are used.

In order to prevent the UV-curable potting material 50 from leaking out of the housing 7, at least parts of the power semiconductor module arrangement 100 are irradiated with ultraviolet light, thereby triggering a cross-linking of the potting material 50. In particular, a first portion of the potting material 50 is irradiated in areas of the potting material 50 near an interface between the substrate 10 and the sidewalls of the housing 7 so as to seal any gaps between the substrate 10 and the sidewalls of the housing 7. "Near" in this respect refers to any portion of the potting material 50 within a radius of, e.g., up to 5mm (millimeters), up to 10mm, up to 20mm, or even up to 30mm, around the interface between the substrate 10 and the sidewalls of the housing 7. This is schematically illustrated in Figure 3. At least an edge region (first portion indicated in dashed circles in Figure 3) of the substrate 10 is irradiated with ultraviolet light, such that a cross-linking of the potting material 50 is triggered primarily in areas of the potting material 50 that are closest to the sidewalls of the housing 7. The areas closest to where the sidewalls of the housing 7 contact the substrate 10 are the areas where the potting material 50 may potentially leak out of the housing 7. By starting the cross-linking process specifically in these areas, the cross-linked potting material 50 itself forms a barrier, seals any gaps between the substrate 10 and the sidewalls of the housing 7, and prevents any potting material 50 that has not yet been cross-linked from leaking out of the housing 7. The viscosity of the potting material 50 increases rapidly once the cross-linking has been triggered by means of the ultraviolet light. The potting material 50 may change from a liquid, viscous or semi-liquid state to a cured, pasty, hardened or solid state when the cross-linking takes place. The method further comprises irradiating a second portion of the potting material 50 farther away from the interface between the substrate 10 and the sidewalls of the housing 7 than the first portion of the potting material 50 to form an encapsulant 52, wherein irradiation of the first and second portions of the potting material takes place at different times and/or via different radiation sources.

The encapsulant 52 is formed by sufficiently hardening the first and second portion of the potting material 50. This may be achieved solely by irradiating the potting material 50 with ultraviolet light. It is, however, also possible that additional hardening steps follow an initial cross-linking process. An additional hardening process may comprise an additional irradiating step, wherein the additional irradiating step comprises irradiating the entire power semiconductor module arrangement 100 with ultraviolet light. It is, however, also possible that the power semiconductor module arrangement 100 is exposed to humidity during an additional hardening process.

Irradiating the power semiconductor module arrangement 100 (e.g., the first portion and/or the second portion of the potting material 50) may comprise irradiating the power semiconductor module arrangement 100 by means of an ultraviolet light source 90 arranged on a side of the substrate 10 that faces the housing 7 (UV light source 90 arranged above the power semiconductor module arrangement 100 in Figure 3). In this case, it may be advantageous to first dispense only a thin layer of potting material 50 on the substrate 10, sufficient to cover the interface between the housing 7 and substrate 10, then to irradiate this thin layer near the edges of the substrate 10 to harden the potting material 50 and seal the interface. Then the housing 7 can be filled with potting material 50 to a final desired level before irradiating the remaining potting material to rapidly cure it. Alternatively or additionally, irradiating the power semiconductor module arrangement 100 (e.g., the first portion and/or the second portion of the potting material 50) may comprise irradiating the power semiconductor module arrangement 100 by means of an ultraviolet light source 90 arranged on a side of the substrate 10 that faces away from the housing 7 (UV light source 90 arranged below the power semiconductor module arrangement 100 in Figure 3). It is generally possible that the entire power semiconductor module arrangement 100 is equally irradiated by the ultraviolet light. It is, however, generally sufficient to at least irradiate those areas that are closest to the edges of the substrate 10, in order to form a barrier and seal the housing before any potting material 50 can leak out of the housing 7. For example, at least areas within a defined distance or radius d1 from or around the edges of the substrate 10 may be irradiated. The defined distance d1 may be, e.g., up to 1cm, up to 2cm or up to 3cm. The housing 7 may contact the substrate 10 within this defined distance d1. Once the cross-linking of the potting material 50 has been triggered, any gaps between the housing 7 and the substrate 10 are sealed solely by means of the resulting encapsulant 52 formed by cross-linking the potting material 50.

A time that passes between the step of filling the potting material 50 into the housing 7 (filling the potting material 50 into the housing 7 has been completed) and the step of irradiating the first portion of the potting material 50 may depend on the fluidity (or viscosity) of the potting material 50. That is, if the fluidity is high (viscosity is low) the time that passes between filling the potting material 50 into the housing 7 and irradiating the first portion of the potting material 50 may be comparably short, as the potting material 50 may leak out of the housing 7 comparably fast. If, on the other hand, the fluidity is low (viscosity is high) the time that passes between filling the potting material 50 into the housing 7 and irradiating the first portion of the potting material 50 may be comparably long, as the potting material 50 may not leak out of the housing 7 very fast. Generally, the time that passes between filling the potting material 50 into the housing 7 and irradiating the first portion of the potting material 50 may be zero seconds, up to 30s (seconds), up to one minute or in few cases even up to several minutes, depending on the fluidity of the respective potting material 50. For example, the time that passes between filling the potting material 50 into the housing 7 and irradiating the first portion of the potting material 50 may be less than five minutes.. However, this irradiation step generally takes significantly less time than the gluing and glue curing steps associated with conventional assembly processes, even when low fluidity gels are used.

Irradiating the exterior of the semiconductor module housing 7 and of the UV-curable potting material 50 inside the housing 7 takes place simultaneously. Because the volume of the material 50 inside the housing 7 is far greater than the volume of potting material 50 emerging at the interface between the housing 7 and substrate 10, however, curing at the interface (first portion of potting material 50) will complete more rapidly at the external locations. The semiconductor module may be irradiated by a UV light source 90 beneath the module and by a further UV light source 90 above the module, for example. Once curing is complete at the interface between the housing 7 and substrate 10, the UV light source 90 beneath the module may be switched off, while the UV light source 90 above the housing may remain on until the UV-curable potting material 50 inside the housing 7 (second portion of potting material 50) is fully cured.

The method for forming a power semiconductor module arrangement according to the embodiments described above requires less manufacturing steps than conventional methods. The method, therefore, requires less manufacturing time and is therefore very cost-effective. Any thermal stress which may arise during the step of hardening a glue that attaches the housing 7 to the substrate 10 is entirely avoided by the methods described herein. Methods for forming a power semiconductor module arrangement 100 comprising a housing 7 have been described with respect to Figures 1 to 3 above. It is, however, also possible to form a power semiconductor module arrangement 100 without a housing 7 similar to what has been described above.

Now referring to Figure 4, methods for forming a power semiconductor module arrangement 100 without a housing 7 according to examples not falling under the scope of the claims will be described in more detail. The power semiconductor module arrangement 100 as illustrated in Figure 4 comprises a substrate 10 with semiconductor bodies 20 and additional elements (e.g., terminal elements 4, or electrical connections 3) arranged thereon. An encapsulant 52 is formed on the substrate 10 by applying a UV-curable potting material 50 to the substrate 10, similar to what has been described above (e.g., by means of a dispensing equipment 80). According to some embodiments of the disclosure, the dispensing equipment 80 may be arranged centrally above the substrate 10. That is, the potting material 50 is dispensed centrally on the substrate 10 and, from there, spreads towards the edges of the substrate 10. The exterior sections along the edges of the substrate 10 are irradiated with ultraviolet light (e.g., by means of one or more ultraviolet light sources 90) such that a cross-linking of the UV-curable potting material 50 is triggered as soon as it reaches the edges of the substrate 10. In this way, a barrier or dam 54 is formed that extends circumferentially along the edges of the substrate 10 which prevents the still liquid, viscous or semi-liquid UV-curable potting material 50 in the central areas of the substrate 10 (inside the volume defined by the dam 54) from flowing off the substrate 10. The central areas of the substrate 10, however, are not initially irradiated with ultraviolet light such that the potting material 50 inside the dam 54 can still freely flow inside the volume defined by the dam 54, forming an even layer of potting material 50 within the dam 54. The dam 54 may be formed to have a thickness d2 in a horizontal direction of between 0.5cm and 3cm, or between 1cm and 2cm, for example.

A shading tool or masking tool 84 may be arranged above the substrate 10 (e.g., on a side of the substrate 10 from where the potting material 50 is applied), in order to prevent any ultraviolet light from reaching the central area of the substrate 10. One or more ultraviolet light sources 90 may be arranged on the same side of the substrate 10 as the shading or masking tool 84, wherein the shading or masking tool 84 is arranged between the one or more light sources 90 and the substrate 10.

When the dam 54 formed by the cross-linked potting material 50 along the edges of the substrate 10 has been formed and has a desired height h2 (e.g., up to several centimeters) in a vertical direction y, and the volume inside of the dam 54 has been filled with further UV-curable potting material 50, the remaining areas of the substrate 10 may be irradiated with ultraviolet light, thereby triggering a cross-linking of the remaining potting material 50, and forming the encapsulant 52.

According to some embodiments, a housing is arranged on the substrate 10 once the encapsulant 52 has been formed. It is, however, also possible that no housing 7 is mounted to the substrate 10. If, for example, the encapsulant 52 is sufficiently hard (e.g., rigid molding compound), the encapsulant 52 alone may be sufficient in order to protect the substrate 10 and the components mounted thereon from any mechanical damage and any environmental conditions.

Summarizing the above, a method for forming a power semiconductor module arrangement 10 according to examples not falling under the scope of the claims comprises applying a liquid, viscous or semi-liquid UV-curable potting material 50 to a substrate 10, irradiating exterior sections along the edges of the substrate 10 with ultraviolet light, thereby triggering a cross-linking of the potting material 50 along the edges of the substrate 10 and forming a dam 54 extending circumferentially along the edges of the substrate 10, filling a volume defined by the dam 54 with UV-curable potting material 50, and, after forming the dam 54 and filling a volume defined by the dam 54 with potting material 50, irradiating the volume of UV-curable potting material 50 with ultraviolet light, thereby triggering a cross-linking process of the remaining potting material 50 and forming an encapsulant 52 covering the substrate 10.

Depending on the specific materials used as a potting material 50, a cross-linking may be triggered within less than 10 seconds, less than 5 seconds or even within 1 second or less when the potting material 50 is irradiated with ultraviolet light. That is, the cross-linking is started (almost) instantaneously. This is generally not the case when the potting material 50 is hardened by means of a thermal process (e.g., by heating the potting material 50 to a defined temperature). Cross-linking the potting material 50 by means of conventional thermal processes generally requires several minutes or even up to several hours. Once the cross-linking has been triggered, the potting material 50 remains in its current position and any further flow of the potting material 50 is prevented. The methods described above by means of Figures 1 to 4 may be performed in a vacuum chamber, for example. In particular, at least one of the irradiating steps may be performed in a vacuum chamber.

## Claims

1. A method for forming a power semiconductor module arrangement (100), the method comprising:
arranging a housing (7) on a substrate (10), wherein the housing (7) comprises sidewalls and is arranged to directly adjoin the substrate (10) such that the substrate (10) forms a base surface of the housing (7);
filling a liquid, viscous or semi-liquid UV-curable potting material (50) into the housing (7), thereby covering the substrate (10) with the potting material (50);
irradiating, with ultraviolet light, a first portion of the potting material (50) in areas of the potting material (50) near an interface between the substrate (10) and the sidewalls of the housing (7), thereby triggering a cross-linking of the first portion of the potting material (50) so as to seal any gaps between the substrate (10) and the sidewalls of the housing (7), and
irradiating, with ultraviolet light, a second portion of the potting material (50) farther away from the interface between the substrate (10) and the sidewalls of the housing (7) than the first portion of the potting material (50), thereby triggering a cross-linking of the second portion of the potting material (50) to form an encapsulant (52), wherein:
the step of irradiating the first portion takes place before the step of irradiating the second portion of the potting material and/or the steps of irradiating the first portion and irradiating the second portion take place via different radiation sources.

2. The method of claim 1, wherein irradiating the first portion of the potting material (50) is performed by an ultraviolet light source (90) arranged on a side of the substrate (10) that faces away from the housing (7).

3. The method of claim 1 or 2, wherein irradiating the second portion of the potting material (50) is performed by an ultraviolet light source (90) arranged on a side of the substrate (10) that faces the housing (7).

4. The method of any of claims 1 to 3, wherein the potting material (50) has a defined viscosity, and a time that passes between filling the potting material (50) into the housing (7) and irradiating the first portion of the potting material (50) depends on the viscosity of the potting material (50).

5. The method of claim 4, wherein the time that passes between filling the potting material (50) into the housing (7) and irradiating the first portion of the potting material (50) is less than five minutes.

6. The method of any of the preceding claims, wherein filling a liquid, viscous or semi-liquid UV-curable potting material (50) into the housing (7) comprises filling a potting material (50) into the housing (7) that has a viscosity of at least 900 mPa*s.

7. The method of any of the preceding claims, further comprising, after forming the encapsulant (52) by cross-linking the potting material (50), performing an additional hardening process, thereby further hardening the encapsulant (52).

8. The method of any of claims 1 to 7, wherein arranging the housing (7) on the substrate (10) comprises attaching the housing (7) to the substrate (10) by means of a mechanical connection, wherein the housing (7) is attached to the substrate (10) solely by means of the mechanical connection.

9. The method of any of the preceding claims, wherein at least one of the irradiation steps is performed in a vacuum chamber.

## Patentansprüche

1. Verfahren zum Bilden einer Leistungshalbeitermodulanordnung (100), wobei das Verfahren Folgendes umfasst:
Anordnen eines Gehäuses (7) auf einem Substrat (10), wobei das Gehäuse (7) Seitenwände umfasst und so angeordnet wird, dass es direkt an das Substrat (10) angrenzt, so dass das Substrat (10) eine Grundfläche des Gehäuses (7) bildet;
Füllen eines flüssigen, viskosen oder halbflüssigen UV-härtbaren Vergussmaterials (50) in das Gehäuse (7), wodurch das Substrat (10) mit dem Vergussmaterial (50) bedeckt wird;
Bestrahlen, mit ultraviolettem Licht,
eines ersten Teils des Vergussmaterials (50) in Bereichen des Vergussmaterials (50) nahe einer Grenzfläche zwischen dem Substrat (10) und den Seitenwänden des Gehäuses (7), wodurch eine Vernetzung des ersten Teils des Vergussmaterials (50) ausgelöst wird, um etwaige Spalte zwischen dem Substrat (10) und den Seitenwänden des Gehäuses (7) abzudichten, und
Bestrahlen, mit ultraviolettem Licht,
eines zweiten Teils des Vergussmaterials (50) weiter entfernt von der Grenzfläche zwischen dem Substrat (10) und den Seitenwänden des Gehäuses (7) als der erste Teil des Vergussmaterials (50), wodurch eine Vernetzung des zweiten Teils des Vergussmaterials (50) ausgelöst wird, um ein Verkapselungsmaterial (52) zu bilden, wobei:
der Schritt des Bestrahlens des ersten Teils vor dem Schritt des Bestrahlens des zweiten Teils des Vergussmaterials erfolgt und/oder die Schritte des Bestrahlens des ersten Teils und des Bestrahlens des zweiten Teils über unterschiedliche Strahlungsquellen erfolgen.

2. Verfahren nach Anspruch 1, wobei das Bestrahlen des ersten Teils des Vergussmaterials (50) durch eine Ultraviolettlichtquelle (90) durchgeführt wird, die auf einer Seite des Substrats (10) angeordnet ist, die von dem Gehäuse (7) abgewandt ist.

3. Verfahren nach Anspruch 1 oder 2, wobei das Bestrahlen des zweiten Teils des Vergussmaterials (50) durch eine Ultraviolettlichtquelle (90) durchgeführt wird, die auf einer Seite des Substrats (10) angeordnet ist, die dem Gehäuse (7) zugewandt ist.

4. Verfahren nach einem der Ansprüche 1 bis 3, wobei das Vergussmaterial (50) eine definierte Viskosität aufweist und eine Zeit, die zwischen dem Füllen des Vergussmaterials (50) in das Gehäuse (7) und dem Bestrahlen des ersten Teils des Vergussmaterials (50) vergeht, von der Viskosität des Vergussmaterials (50) abhängt.

5. Verfahren nach Anspruch 4, wobei die Zeit, die zwischen dem Füllen des Vergussmaterials (50) in das Gehäuse (7) und dem Bestrahlen des ersten Teils des Vergussmaterials (50) vergeht, weniger als fünf Minuten beträgt.

6. Verfahren nach einem der vorhergehenden Ansprüche, wobei das Füllen eines flüssigen, viskosen oder halbflüssigen UV-härtbaren Vergussmaterials (50) in das Gehäuse (7) Füllen eines Vergussmaterials (50) in das Gehäuse (7), das eine Viskosität von mindestens 900 mPa*s aufweist, umfasst.

7. Verfahren nach einem der vorhergehenden Ansprüche, ferner umfassend, nach dem Bilden des Verkapselungsmaterials (52) durch Vernetzen des Vergussmaterials (50), Durchführen eines zusätzlichen Härtungsprozesses, wodurch das Verkapselungsmaterial (52) weiter gehärtet wird.

8. Verfahren nach einem der Ansprüche 1 bis 7, wobei das Anordnen des Gehäuses (7) auf dem Substrat (10) Anbringen des Gehäuses (7) an dem Substrat (10) mittels einer mechanischen Verbindung umfasst, wobei das Gehäuse (7) ausschließlich mittels der mechanischen Verbindung an dem Substrat (10) angebracht wird.

9. Verfahren nach einem der vorhergehenden Ansprüche, wobei mindestens einer der Bestrahlungsschritte in einer Vakuumkammer durchgeführt wird.

## Revendications

1. Un procédé de formation d'un agencement (100) de module à semiconducteur de puissance, le procédé comprenant :
mettre un boîtier (7) sur un substrat (10), dans lequel le boîtier (7) comprend des parois latérales et est mis pour s'adjoindre directement au substrat (10) de manière à ce que le substrat (10) forme une surface de base du boîtier (7) ;
remplir le boîtier (7) d'une matière (50) d'enrobage liquide, visqueuse ou semi-liquide, durcissable par les UV, en recouvrant ainsi le substrat (10) de la matière (50) d'enrobage ;
exposer, à de la lumière ultraviolette, une première partie de la matière (50) d'enrobage dans des zones de la matière (50) d'enrobage, proches d'une interface entre le substrat (10) et les parois latérales du boîtier (7), en déclenchant ainsi une réticulation de la première partie de la matière (50) d'enrobage, de manière à sceller tout intervalle entre le substrat (10) et les parois latérales du boîtier (7), et
exposer, à de la lumière ultraviolette, une deuxième partie de la matière (50) d'enrobage, plus loin de l'interface entre le substrat (10) et les parois latérales du boîtier (7), que la première partie de la matière (50) d'enrobage, en déclenchant ainsi une réticulation de la deuxième partie de la matière (50) d'enrobage pour former un enrobage (52), dans lequel :
le stade d'exposition de la première partie a lieu avant le stade d'exposition de la deuxième partie de la matière d'enrobage et/ou les stades d'exposition de la première partie et d'exposition de la deuxième partie ont lieu par des sources de rayonnement différentes.

2. Le procédé de la revendication 1, dans lequel exposer la première partie de la matière (50) d'enrobage est effectué par une source (90) de lumière ultraviolette disposée sur une face du substrat (10), qui est loin du boîtier (7).

3. Le procédé de la revendication 1 ou 2, dans lequel exposer la deuxième partie de la matière (50) d'enrobage est effectué par une source (90) de lumière ultraviolette disposée sur une face du substrat (10), qui est en face du boîtier (7).

4. Le procédé de l'une quelconque des revendications 1 à 3, dans lequel la matière (50) d'enrobage a une viscosité définie et un temps, qui se passe entre le remplissage du boîtier (7) par la matière (50) d'enrobage et l'exposition de la première partie de la matière (50) d'enrobage, dépend de la viscosité de la matière (50) d'enrobage.

5. Le procédé de la revendication 4, dans lequel le temps, qui se passe entre le remplissage du boîtier (7) de la matière (50) d'enrobage et l'exposition de la première partie de la matière (50) d'enrobage, est plus petit que cinq minutes.

6. Le procédé de l'une quelconque des revendications précédentes, dans lequel remplir le boîtier (7) d'une matière (50) d'enrobage liquide, visqueuse ou semi-liquide, durcissable par les UV comprend remplir le boîtier (7) d'une matière (50) d'enrobage d'une viscosité d'au moins 900 mPa*s.

7. Le procédé de l'une quelconque des revendications précédentes, comprenant en outre, après avoir formé l'enrobage (52) en réticulant la matière (50) d'enrobage, effectuer une opération supplémentaire de durcissement, en durcissant ainsi davantage l'enrobage (52).

8. Le procédé de l'une quelconque des revendications 1 à 7, dans lequel mettre le boîtier (7) sur le substrat (10) comprend fixer le boîtier (7) au substrat (10) au moyen d'une connexion mécanique, dans lequel le boîtier (7) est fixé au substrat (10) seulement au moyen de la connexion mécanique.

9. Le procédé de l'une quelconque des revendications précédentes, dans lequel on effectue au moins l'une des expositions dans une chambre sous vide.
